(19) Europäisches Patentamt / European Patent Office / Office européen des brevets

(11) **EP 1 979 769 B1**

(12) **EUROPÄISCHE PATENTSCHRIFT**

(45) Veröffentlichungstag und Bekanntmachung des Hinweises auf die Patenterteilung:
**07.09.2011 Patentblatt 2011/36**

(51) Int Cl.:
*G02B 3/00* (2006.01)    *H04N 5/335* (2011.01)
*H04N 5/225* (2006.01)

(21) Anmeldenummer: **07711414.8**

(22) Anmeldetag: **23.01.2007**

(86) Internationale Anmeldenummer:
**PCT/EP2007/000813**

(87) Internationale Veröffentlichungsnummer:
**WO 2007/082781 (26.07.2007 Gazette 2007/30)**

(54) **BILDERFASSUNGSSYSTEM UND VERFAHREN ZUR HERSTELLUNG MINDESTENS EINES BILDERFASSUNGSSYSTEMS**

IMAGE DETECTION SYSTEM AND METHOD FOR PRODUCING AT LEAST ONE IMAGE DETECTION SYSTEM

SYSTEME DE SAISIE D'IMAGE ET PROCEDE DE FABRICATION D'AU MOINS UN SYSTEME DE SAISIE D'IMAGE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **23.01.2006 DE 102006004802**

(43) Veröffentlichungstag der Anmeldung:
**15.10.2008 Patentblatt 2008/42**

(73) Patentinhaber: **Fraunhofer-Gesellschaft zur Förderung der angewandten Forschung e.V.**
**80686 München (DE)**

(72) Erfinder:
• **DUPARRÉ, Jacques**
**07745 Jena (DE)**
• **DANNBERG, Peter**
**07745 Jena (DE)**
• **BRÜCKNER, Andreas**
**07743 Jena (DE)**
• **BRÄUER, Andreas**
**07646 Schlöben (DE)**

(74) Vertreter: **Pfenning, Meinig & Partner GbR Patent- und Rechtsanwälte Joachimstaler Strasse 12 10719 Berlin (DE)**

(56) Entgegenhaltungen:
EP-A- 0 840 502      WO-A-2005/069607
DE-A1- 19 755 565    JP-A- 2001 237 404
US-A1- 2001 026 322

EP 1 979 769 B1

**Beschreibung**

Die Erfindung betrifft ein Bilderfassungssystem nach dem Oberbegriff des Hauptanspruchs sowie ein Verfahren zur Herstellung mindestens eines Bilderfassungssystems.

Ein solches Bilderfassungssystem ist aus der WO 2005/069607 A1 bekannt, bei dem regelmäßig angeordnete optische Kanäle mit jeweils einer Mikrolinse und mindestens einem in deren Bildebene liegenden Detektor vorgesehen sind, wobei aus dem Mikrobild hinter der Mikrolinse mindestens ein Bildpunkt extrahiert wird. Die optischen Achsen der einzelnen optischen Kanäle weisen unterschiedliche Neigungen derart auf, dass sie eine Funktion des Abstandes des optischen Kanals vom Mittelpunkt der zum Bild gewandten Seite des Bilderfassungssystems darstellen. Damit ist das Verhältnis der Größe des Gesichtsfeldes zur Bildfeldgröße gezielt bestimmbar. Es werden Detektoren mit derart hoher Empfindlichkeit eingesetzt, dass diese einen großen Mittenabstand bzw. Pitch bei kleiner aktiver Fläche aufweisen.

Bei diesem bekannten Bilderfassungssystem wird zum Beispiel durch eine Differenz im Zentrumsabstand bzw. Mittenabstand der Mikrolinsen und der Detektoren ein lineares Anwachsen der Neigung der optischen Achsen von Kanal zu Kanal erreicht. Jeder optische Kanal, dem eine Mikrolinse, eine dieser zugeordneten Apertur-blende und ein Detektor, ggf. mit Lochblende, zugeordnet ist, "sieht" dadurch in die benachbarte Richtung der an ihn anschließenden Kanäle. Durch Auslesen der Detektorsignale in Form einer Matrix, in der in Reihe und ggf. Spalte nach die Signale der Detektoren eingetragen sind, folgt ohne weitere Sortierung der Signale der Detektoren das Bild des betrachteten Objektes. Es ist damit möglich, aus der Koordinate eines Kanals im Array formelmäßig seine Blickrichtung innerhalb des gesamten Gesichtsfeldes der Kamera bzw. des Bilderfassungs systems zu bestimmen, ein zweidimensionales Bild eines begrenzten Gesichtsfeldes entsteht.

Im Falle großer Einfallswinkel von Bereichen außerhalb des Gesichtsfeldes des Objektivs kommt es bei fehlender optischer Isolation der Kanäle zum Übersprechende des Lichts von Linsen eines Kanals auf Detektoren ggf. mit Lochblenden benachbarter Kanäle und damit zur Ausbildung von Geisterbildern. Um dies zu verhindern, wurden in der genannten WO 2005/069607 verschiedene Anordnungen, im speziellen absorbierende Trennwände zwischen den Kanälen vorgeschlagen. Diese Anordnung ist jedoch mit einem hohen technologischen Aufwand, besonders bei der Herstellung der Replikationswerkzeuge, bzw. durch die Notwendigkeit von Photolithographieprozessen mit hohen Aspektverhältnissen verbunden. Außerdem ist das Bildfeld begrenzt, da der zugeordnete Detektorpixel in der Projektion der Mikrolinse liegen muss.

Der kleinste auflösbare Winkelabstand bzw. bei bekanntem Objektabstand die kleinste auflösbare Strukturgröße beträgt bei dem in der WO 2005/069607 beschriebenen Bilderfassungssystem das Doppelte der Blickwinkeldifferenz, d.h. der Neigungsdifferenz der optische Achsen zwischen benachbarten Kanälen. Das Winkelauflösungsvermögen eines ultra-flachen Kamerasystems wird für ein gewünschtes Gesichtsfeld u.a. durch die Kantenlängen des Detektorarrays und der damit verbundenen maximalen Anzahl von Kanälen in den Hauptsymmetrieachsen begrenzt. Eine Steigerung des Winkelauflösungsvermögens durch Erhöhung der Anzahl an optischen Kanälen erfordert die kostspielige Vergrößerung der Siliziumfläche des Detektorarrays. Bei vielen einfachen Abbildungsaufgaben, z.B. Fahrstreifenerkennung, Kantenpositionsdetektion oder dgl. wird ein moderates Auflösungsvermögen über ein großes Gesichtsfeld benötigt. Bildgebende Systeme, die diese Spezifikationen mit wenigen, parallel abbildenden Kanälen umsetzen, zeichnen sich gegenüber hochauflösenden Megapixel-Kameras durch eine geringere Komplexität sowie schnelle Bildverarbeitung und nicht zuletzt niedrigere Herstellungskosten aus. Herkömmliche makroskopische Objektive für eine verzeichnungsfreie Abbildung eines großen Gesichtsfeldes sind sehr aufwendig und teuer. Die Bildqualität nimmt bei diesen Objektiven zum Rand des Gesichtsfeldes hin ab und nicht korrigierte Verzeichnung verzerrt das Bild, so dass Objekte nicht mehr eindeutig identifiziert werden können. Durch die in der genannten Druckschrift beschriebenen Freiheitsgrade kanalweise abbildender Systeme können diese Probleme durch die individuelle Korrektur jedes Kanals auf seine individuelle Blickrichtung teilweise kompensiert werden. Die planare Bauweise bietet hier den zusätzlichen Vorteil der Raumersparnis.

Die JP 2001 237 404 A offenbart einen Bildsensor, der zur Erhöhung des optischen Füllfaktors (Verhältnis von effektiver photo-aktiver Fläche zur gesamten Detektorfläche) ein Linsenarray und ein Detektorarray, zwischen denen mehrere Schichten von Blendenarrays angeordnet sind, aufweist, wobei eine Pitchdifferenz zwischen Linsenarray und Detektorarray eingeführt ist, um einen Abfall der Beleuchtungsstärke zum Bildfeldrand hin zu verhindern. Die Blendenlagen sind ebenso versetzt und zusätzlich sind die Öffnungen der Blenden zu den Detektoren zum Rand hin versetzt. Die in der Druckschrift beschriebene Anordnung wird in der Bildebene z.B. einer konventionellen Kamera verwendet, wo sie aufgrund der lichtbündelnden Wirkung der Mikrolinsen direkt über den photo-aktiven Detektorflächen eine Erhöhung der Lichtempfindlichkeit des Gesamtsystems bewirkt. Es handelt sich demnach nicht um eine eigenständig abbildende Anordnung.

Der Erfindung liegt unter Berücksichtigung des genannten Standes der Technik der WO 2005/069 607 die Aufgabe zugrunde, ein Bilderfassungssystem entsprechend dem Obergriff des Hauptanspruchs zu schaffen, das eine Geisterbildunterdrückung gestattet und das ein vergrößertes abtastbares Bildfeld zur Verfügung stellt.

Diese Aufgabe wird erfindungsgemäß durch die kennzeichnenden Merkmale des Hauptanspruchs in Verbindung mit den Merkmalen des Oberbegriffs gelöst.

Durch die in den Unteransprüchen angegebenen Maßnahmen sind vorteilhafte Weiterbildungen und Verbesserungen möglich.

Das erfindungsgemäße Bilderfassungssystem löst das Problem der Geisterbildunterdrückung durch zusätzlich zwischen Mikrolinsen und diesen zugeordneten Aperturblenden und Detektoren, die als Detektorpixel allein oder als Detektorpixel mit diese einschnürenden Lochblenden definiert sind, eingebrachte, versetzte Blenden. Dabei können ein- oder mehrere zusätzliche Blendenarrays zwischen dem Mikrolinsenarray und den Detektorarray, deren Zentrumsabstand zwischen dem der Mikrolinsen und der Detektoren liegt, vorgesehen sein, so dass in dem dafür, vorgesehenen Kanal Licht eines bestimmten Einfallswinkels, für den gerade alle Blendenöffnungen mit Linse und Detektor auf einer Geraden liegen, von einer Linse auf den ihr zugeordneten Detektor fokussiert wird und alle anderen Einfallswinkel durch die eine zusätzliche Blende oder durch mehrere zusätzliche Blenden kurz vor der Bildebene der Mikrolinse gesperrt, d.h. absorbiert oder reflektiert werden. Dadurch ergibt sich für das gesamte Konzept des beschriebenen flachbauenden Bilderfassungssystems im Gegensatz zur Einführung von absorbierenden Trennwänden zwischen den Kanälen entsprechend dem Stand der Technik ein wesentlicher Vorteil, der darin liegt, dass ein einer Linse oder einem Kanal zugeordneter Detektor sich nicht notwendigerweise direkt im "Fußabdruck" (Projektion), also direkt hinter dieser Mikrolinse befinden muss, sondern kann zur Erreichung eines größeren Blickwinkels des Kanals auch stark versetzt hinter der Nachbarlinse oder übernächste Nachbarlinse oder weiterer angeordnet sein kann, ohne dass Geisterbilder durch übersprechen des Lichts entstehen. Damit wird effektiv das abtastbare Bildfeld der Mikrolinsen größer und es folgt ein größeres Orts-Sandbreite-Produkt, was sich vorteilhaft hinsichtlich Auflösungsvermögen, Gesichtsfeldgröße und Lichtstärke des abbildenden Systems auswirkt. Weiterhin kann, da keine Trennwände vorgesehen werden müssen, ein durchgehender ununterbrochener Objektivkörper verwendet werden, der die Stabilität der Objektivanordnung verbessert, u.a. auch durch einen angepassten thermischen Ausdehnungskoeffizienten des Objektivkörpers bezüglich dem des optoelektronischen Bildsensors.

Jede Linse kann durch die zusätzliche zugeordnete Blende ausschließlich auf den ihr zugeordneten Detektor, nicht aber auf den Detektor der Nachbarlinsen fokussieren, da nur für den jeweils für den Kanal vorgesehen Einfallswinkel die oder alle Blendenöffnungen auf einer Achse liegen. Die Größe der Blendenöffnungen, bei mehreren übereinanderliegenden Blendenarrays in den verschiedenen Lagen, ist jeweils an den Durchmesser des fokussierten Lichtkegels in dem entsprechenden Abstand hinter der Mikrolinse angepasst, der Versatz der jeweiligen Blende relativ zur Linse bzw. zu dem Detektor an den mit dem jeweiligen Kanal abzubildenden Einfallswinkel.

In vorteilhafter Weise können Art, Form und Parameter der Mikrolinsen zur Korrektur von off-axis-Bildfehlern durch kanalweise Anpassung an die jeweilige Blickrichtung verwendet werden. Neben der standardmäßigen Nutzung von Arrays runder Linsen können Arrays variabler elliptischer (anamprphotischer) Linsen zur Korrektur von Astigmatismus und Bildfeldwölbung und asphärische off-axis-Linsensegmente zur Steigerung des Gesichtsfeldes und der Auflösung bei vollständiger Aberrationskorrektur für die jeweilige Blickrichtung eingesetzt werden.

Es gibt verschiedene Varianten der Pitchabstufungen zwischen den verschiedenen Elementen, d.h. der verschiedenen Ebenen, so können die Aperturblenden der Mikrolinsen direkt unter diesen zentriert sein, aber auch eine Pitchdifferenz zu diesen besitzen. Die Pitchdifferenz (d.h. die. Differenz zwischen den jeweiligen Mittenabständen) zwischen Linsen und Detektorpixeln bzw. Lochblenden kann positiv oder negativ sein, die optischen Achsen sind dann entweder nach innen oder außen gerichtet, das entstehende Bild ist umgekehrt oder aufrecht.

Grundsätzlich können alle Maßnahmen und Vorteile der WO 2005/069607, bis auf das Vorsehen von Trennwänden zwischen den optischen Kanälen, auch bei der vorliegenden Anmeldung verwendet werden, wobei deshalb die Offenbarung dieser Druckschrift in die vorliegende Anmeldung mit eingeschlossen sein soll.

Vorteilhafterweise kann die Beleuchtung hinsichtlich Lichtemission, -konzentration und -formung des zu erfassenden Objektes mit in das Bilderfassungssystem bzw. in die Kamera integriert werden, beispielsweise indem zwischen den optischen Kanälen etwas Platz gelassen wird, um Lichtquellen anzubringen oder sie kann in gewissem Abstand zwischen Gruppen von Kanälen oder als Ring um die Kamera worgesehen werden. Weiterhin ist es denkbar, auf die Linsenebene, z.B. in die Totzonen zwischen quadratisch gepackten, z.B. runden Linsen, Lichtquellen anzubringen. Ebenso ist es möglich, dass nur manche Linsen der erfindungsgemäßen Anordnung benutzt werden, um auf einen Detektor zu fokussieren und andere dazu benachbarte Linsen das Licht von in der Bildebene der Mikrolinsen befindlichen Quellen auf das zu beobachtende Objekt zu bündeln, zu richten und/oder zu verteilen. Als Lichtquellen können Laserdioden, LEDs oder OLEDs oder VCSEL oder dergleichen verwendet werden.

Als Detektorpixelarrays können CMOS- oder CCD-Sensoren, aber auch Arrays aus Polymerphotodioden verwendet werden, wobei letztere vorteilhaft sind, da eine große Sensorgesamtfläche nicht so hohe Kosten wie bei Si-Empfängern verursacht. Da diese Empfänger in Drucktechnik hergestellt werden können, ebenso die Linsenarrays und auch die verschiedenen Blendenarrays, scheint langfristig das Drucken der gesamten Kamera als Herstellungstechnologie in Frage zu kommen.

In vorteilhafter Weise kann für Farbaufnahmen das beschriebene abbildende System ohne Änderungen übernommen werden, wenn ein Bildsensor, der verschiedene Farben direkt in drei übereinanderliegenden Pixelschichten getrennt aufnimmt, statt ein herkömmlicher Schwarz/Weiß CMOS oder CCD-Sensor als Empfängerarray vorgesehen wird. Solch ein, Bildsensor steht im Gegensatz zur herkömmlichen farbaufnehmenden CMOS- oder CCD-Sensoren, bei denen Farbfilter nebeneinander auf sonst gleichartigen Pixeln angeordnet sind.

Da bei dem erfindungsgemäßen Bilderfassungssystem der benötigte Füllfaktor der Detektorpixel in der Bildebene gering ist, müssen die Detektorpixel nicht notwendig quadratisch oder rechteckig sein, um in einem kartesischen Raster möglichst dicht gepackt zu sein. Vielmehr können andere Gesichtspunkte bei dem Design der Detektorpixel berücksichtigt werden, wie z.B. eine Geometrie des PN-Überganges, die nur einen sehr geringen Dunkelstrom bewirkt und sich damit vorteilhaft auf das Signal-Rausch-Verhältnis auswirkt. So können z.B. kreisrunde Pixel bzw. Pixel mit einer kreisrunden Begrenzung des PN-Überganges verwendet werden.

Das erfindungsgemäße Bilderfassungssystem ist auch zur Abbildung naher (wenige cm) bzw. sehr naher (einige wenige mm) Objekte mit einer Vergrößerung von 1 oder geringer Vergrößerung oder Verkleinerung einsetzbar. Dann ist der Unterschied des Pitches der Elemente, d.h. im Mittenabstand der verschiedenen Schichten, wie Mikrolinsenarray, Blendenarray, Detektorarray Null oder nur sehr gering, allerdings wird je nach Größe des abzubildenden Objektes ein großflächiger Bildsensor benötigt.

Für das Optikdesign ein dieser ca. 1:1 abbildenden Konfiguration ist es vorteilhaft, den objektseitigen Raumwinkel, der jedem Kanal als Bildpunkt zugeordnet wird, genau so in seiner Größe einzustellen, dass im Objektabstand von dem abbildenden System die diesem Raumwinkel entsprechende laterale Objektausdehnung gerade so groß wie der Pitch der Kanäle ist. Solche Systeme können beispielsweise über Korrelationsalgorithmen als optische Maus oder als gering auflösenden flächiges Mikroskop oder statischer Scanner von nahen, ebenen Objekten eingesetzt werden.

In vorteilhafter Weise können die unterschiedlichen Neigungen der optischen Achsen der Kanäle auf die verschiedensten Arten erzielt werden. So können sich die einzelnen Mikrolinsen hinsichtlich der, Dezentrierung gegenüber dem Detektor, der Brennweite, der konischen und/oder asphärischen Parameter unterscheiden. Es können auch in die einzelnen Mikrolinsen Mikroprismen integriert sein, schließlich können die einzelnen Mikrolinsen auf einer konvex oder konkav geformten Basisfläche angeordnet sein.

Zur Beeinflussung der Größe des Gesichtsfeldes können die Detektoren auch auf einer konvex oder konkav geformten Basisfläche angeordnet sein.

Eine vorteilhafte Anwendung der Erfindung ist die höchstgenaue Positionsbestimmung von Punktquellen und Positions- und Orientierungsbestimmung von Kanten, wobei das ultraflache Kamerasystem zur zweidimensionalen Bilderfassung auf Basis von 2D-Mikrolinsenarrays so modifiziert wird, dass sich die Gesichtsfelder benachbarter optischer Kanäle gegenseitig teilweise überlappen. Dies wird z.B. durch die Einstellung des Zentrumsabstandes zwischen Linsenarray und Detektoren oder durch die Vergrößerung der Durchmesser von Lochblenden erreicht, solange diese eine kleinere Flächenausdehnung als die fotosensitiven Detektorpixel besitzen. Beide Maßnahmen sorgen dafür, dass die Blickwinkeldifferenz zwischen benachbarten optischen Kanälen kleiner wird als die halbe effektive Breite des Gesichtsfeldes eines Kanals. Dadurch wird eine Winkelpositionsbestimmung der im gemeinsamen Gesichtsfeldbereich befindlichen einfach strukturierten Objekte, wie Punktquellen, Kanten, niedrigfrequenter Rechteckgitter durch die Auswertung von Verhältnissen der in benachbarten Kanälen gemessenen Intensitätswerte mit einer Genauigkeit erreicht, die jenseits der durch das Auflösungsvermögen des bildgebenden optischen Systems vorgegebenen kleinsten auflösbaren Strukturgröße liegt. Dadurch wird eine höchstgenaue Positionsbestimmung möglich.

Ausführungsbeispiele der Erfindung sind der Zeichnung dargestellt und werden in der nachfolgenden Beschreibung näher erläutert.

Es zeigen

Figur 1   eine schematische Seitenansicht des erfindungsgemäßen Bilderfassungs- systems,

Figur 2   eine Aufsicht auf das erfindungsgemäße Bilderfassungssystem nach Figur 1,

Figur 3   eine Teilansicht des erfindungsgemäßen Bilderfassungssystems nach Figur 1, bei der der Detektor stark versetzt zu der zugehörigen Mikrolinse angeordnet ist,

Figur 4   eine schematische Seitenansicht eines Optowafers und eines Wafers, auf dem sich die Detektorarrays befinden, aus denen durch Vereinzelung das erfin- dungsgemäße Bilderfassungssystem her- gestellt wird;

Figur 5   eine schematische Darstellung des op- tischen Systems des Bilderfassungs- systems mit teilweise überlappenden Gesichtsfeldern benachbarter Kanäle in Seitenansicht (Figur 5A) und eine Darstellung der Winkelempfindlichkeit, aufgetragen über dem Winkel im Gesichtsfeld (Figur 5B) und

Figur 6   eine schematisierte Darstellung der Bestimmung der Winkelposition einer Punktquelle innerhalb des Gesichtsfeldes dreier optischer Kanäle mit überlappenden Gesichtsfeldern.

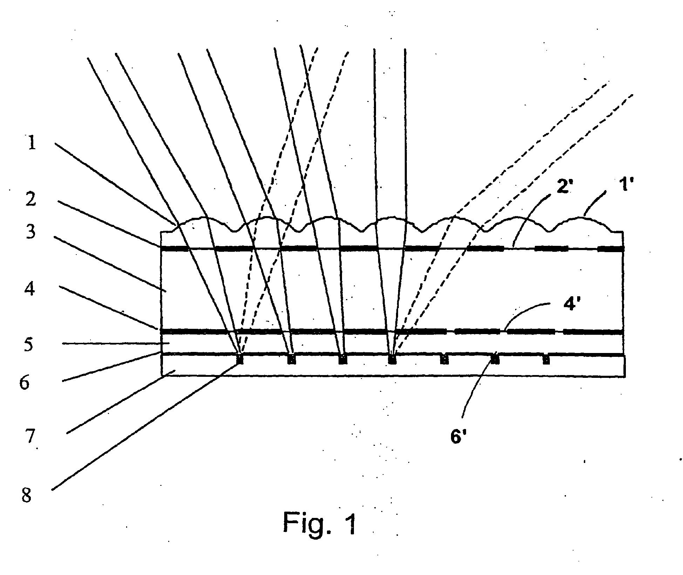

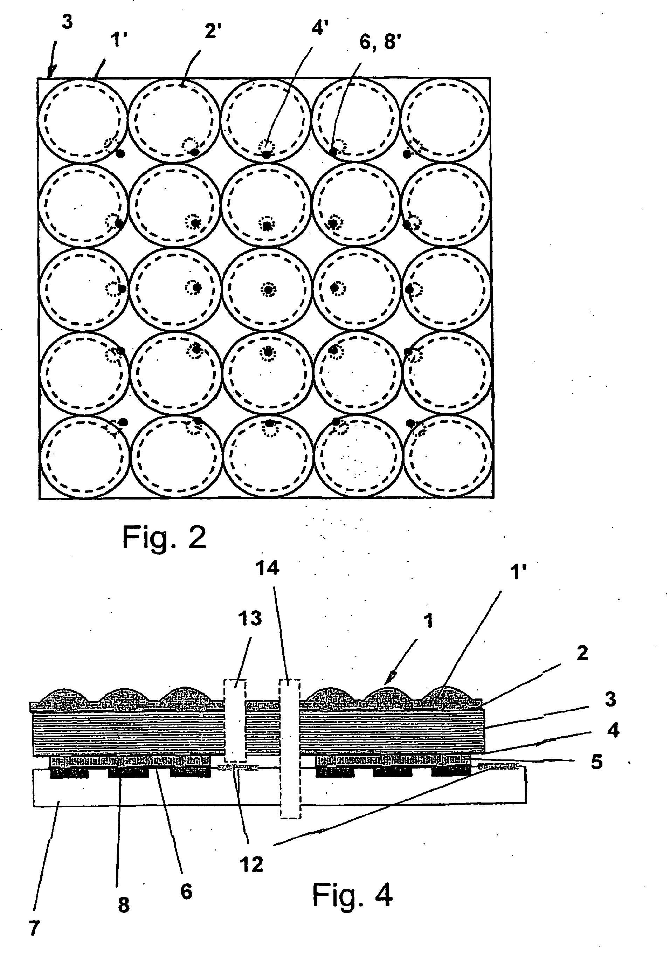

Das in den Figuren 1 und 2 dargestellte Bilderfassungssystem weist einen transparenten Objektivkörper 3 auf, auf den ein Mikrolinsenarray 1 mit einer Vielzahl von einzelnen Linsen 1' aufgebracht ist, wobei im dargestellten Ausführungsbeispiel (Figur 2) die Linsen 1' als runde Mikrolinsen ausgebildet sind. Direkt unterhalb des Mikrolinsenarrays 1 ist ein Aperturblendenarray 2 zwischen Mikrolinsen 1' und Objektivkörper 3 angeordnet. Unterhalb des Objektivkörpers 3 sind Blenden 4', ebenfalls in Form eines Arrays 4, zur Geisterbildunterdrückung kurz vor der Bildebene der Mikrolinsen 1' vorgesehen, wobei in der Bildebene Detektoren liegen, die im Ausführungsbeispiel von Detektorpixeln 8 auf einem Detektorpixelsubstrat 7 und von Lochblenden 6' eines Lochblendenarrays 6 gebildet werden. Das Lochblendenarray 6 kann weggelassen werden, wenn die Fläche der Detektorpixel 8 klein genug ist, d.h. der zugeordnete Detektor ist dann der Detektorpixel 8 selbst. Zwischen Blendenarray 4 zur Geisterbildunterdrückung und dem Lochblendenarray 6 ist eine Abstandsschicht 5 angeordnet. Eine Mikrolinse 1' mit darunterliegender Aperturblende 2', ein der Linse 1' zugeordneter Detektorpixel 8 mit Lochblende 6' und Blende 4' bilden einen optischen Kanal, wobei wie aus Figur 2 zu erkennen ist, mehrere optische Kanäle matrixweise nebeneinander liegen.

Wie aus den Figuren 1 und 2 zu erkennen ist, sind die optischen Achsen jedes optischen Kanals ausgehend von der Mitte des Bilderfässüngeaystems in radialer Richtung in regelmäßige Weise mit unterschiedlichen Neigungen versehen. Dabei ist die optische Achse jedes Kanals als Verbindungslinie zwischen den Scheitel einer Mikrolinse 1' und der Mitte des zugeordneten Detektors, d.h. der Mitte der zugeordneten Lochblende 6' definiert.

In Figur 2 ist die runde Aperturblende 2' einer Mikrolinse durch den großen gestrichelten Kreis dargestellt, die runde Blende 4' kurz vor der Bildebene einer Mikrolinse 1' zur Unterdrückung des Übersprechens ist als kleiner punktierter Kreis und der Detektor, d.h. der von der Lochblende 6' abgedeckte Detektorpixel 8 ist mit einem vollen Punkt ausgeführt. Es ist zu erkennen, dass sowohl die Blenden 4' zur Geisterbildunterdrückung als auch die Detektoren abhängig von der Mitte der Kamera in X- und Y-Richtung, d.h. abhängig von der Position des jeweiligen Kanals unterschiedlich in der Draufsicht versetzt angeordnet sind. Es kann somit gesagt werden, dass die Neigung bzw. Richtung der optischen Achsen eines optischen Kanals, der zwischen einer Mikrolinse 1' und einem aus dem Mikrobild hinter diese Linse einen Bildpunkt extrahierenden Detektor 6, 8 definiert wird, eine Funktion der radialen Koordinate im Array ausgehend von einem Kanal mit senkrechter optischer Achse ist.

Wie aus Figur 1 zu erkennen ist, dient das Blendenarray 4 zwischen dem Mikrolinsenarray 1 und der Detektorebene zur Trennung der optischen Kanäle, wobei mehrere Lagen von Blendenarrays 4 vorgesehen sein können. Der Zentrumsabstand der Löcher bzw. Öffnungen eines Arrays 4 wird gerade so gewählt, dass nur ein Bündel unter dem dafür vorgesehen Einfallswinkel von der Linse auf den zugehörigen Detektor fokussiert wird, andere Einfallswinkel aber blockiert werden. Die Bereiche der Blenden 4' innerhalb der jeweiligen Kreise sind transparent, die Bereiche außerhalb entsprechend absorbierend oder reflektierend, bevorzugt aber absorbierend ausgebildet, um den Streulichtpegel zu reduzieren.

In Figur 1 ist auch die Funktionsweise des Blendenarrays 4 erkennbar. Die gezeigten durchgehenden Strahlenbündel stellen die Hauptblickrichtungen jedes optischen Kanals und die Fokussierung der entsprechenden Bündel dar. Im Gegensatz dazu sollen die gestrichelten Strahlenbündel beispielhaft die Entstehung von Geisterbildern durch das Übersprechen von Licht von Mikrolinsen 1' auf ihnen nicht zugeordnete, d.h. ihrer vorbestimmten Blickrichtung entsprechenden Detektoren ohne das Vorhandensein des Blendenarrays 4 zeigen. Das Übersprechen von Licht würde bei Fokussierung auf benachbarte und/oder auch noch weiter weg liegende Detektoren erzeugt werden. Durch die Einführung des Blendenarrays 4 wird das Übersprechen und damit die Entstehung von Geisterbildern beseitigt.

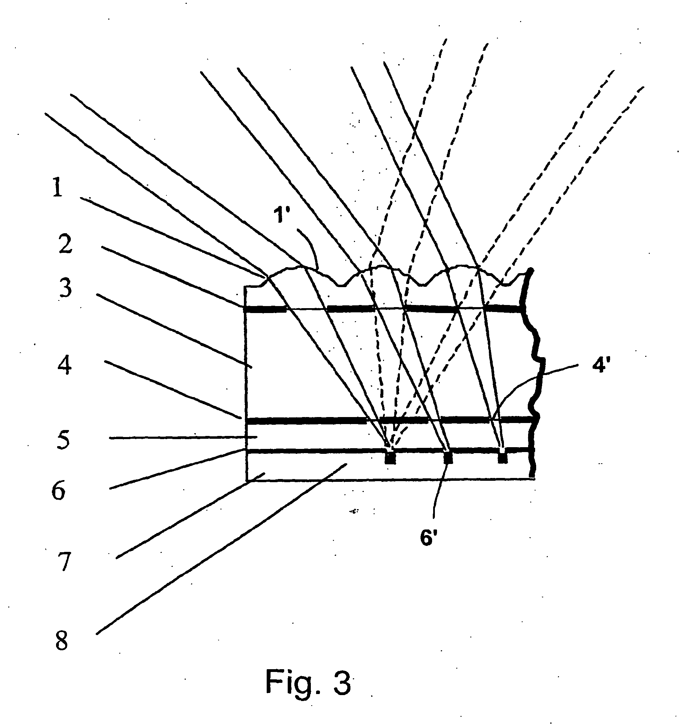

In Figur 3 ist dargestellt, dass ein einer Mikrolinse 1' bzw. einem Kanal zugeordneter Detektor, bestehend aus Detektorpixel 8 und Lochblende 6' im Ausführungsbeispiel, sich nicht notwendigerweise direkt im Fußabdruck, d.h, direkt hinter dieser Mikrolinse 1' befinden muss, sondern zur Erreichung eines größeren Blickwinkels des Kanals, der durch das durchgezogene Strahlenbündel definiert ist, auch stark versetzt hinter der Nachbarlinse oder hinter deren Nachbarlinse angeordnet sein kann, ohne dass Geisterbilder durch Obersprechen, die durch das gestrichelt dargestellte Strahlenbündel repräsentiert sind, entstehen. Damit wird effektiv das abtastbare Bildfeld der Mikrolinsen 1' größer, was sich sehr vorteilhaft hinsichtlich Auflösungsvermögen, Gesichtsfeldgröße und Lichtstärke des abbildenden Systems auswirkt.

Die Zahl der optischen Kanäle kann entsprechend den Anwendungsgebieten in der Größenordnung von 10 x 10 bis 1.000 x 1.000 liegen, wobei eine quadratische Form entsprechend Figur 2 nicht verlangt wird. Die Größe der Mikrolinsen 1' definiert auch die Größe der optischen Kanäle, wobei ein Durchmesser der Mikrolinsen in einem Bereich zwischen 10 μm bis 1 min liegt. Das Mikrolinsenarray 1 besteht aus einem Kunststoff und kann durch die unterschiedlichsten Technologien, wie Pressen, Spritzen oder dergleichen hergestellt werden. Der Objektivkörper 3 kann als Glas oder als transparentes Kunststoffmaterial ausgebildet sein, die Aperturblenden- und Lochblendenarrays können als Metallbeschichtungen, aber auch als schwarzes Polymer ausgebildet sein.

Anhand der Figur 4 soll die Herstellung einer Ausführungsform der flachen Kamera mit Geisterbildunterdrückung beschrieben werden. In dieser Ausführungsform wird das abbildende System durch die vorder- und rückseitige Strukturierung auf einem dünnen Objektivkörper 3, vorzugsweise aus Glas, erzeugt. Dabei werden auf den Objektivkörper 3 zuerst auf der Vorderseite das dem Mikrolinsenarray zugeordnete Aperturblendenarray 2 und auf der Rückseite das Blendenarray 4 zur Geisterbildunterdrückung, z.B. im dünnen, absorbierenden Polymer oder in einem Metall durch Beschichtung und Lithögraphie aufgebracht. Anschließend wird vorderseitig das Linsenarray 1 durch UV-Replikation und rückseitig die Abstandsschicht 5 in einem photoatrukturierbaren polymer hergestellt. Falls die Detektorpixel 8 des Sensorarray durch ein zusätzliches Lochblendenarray 6 in ihrer Größe eingeschränkt werden müssen und falls Letzteres nicht auf dem Detektorsubstrat erzeugt werden kann, wird das Lochblendenarray bzw. die Lochblendenschicht 6 z.B. als Metall oder schwarzes Polymer mit photostrukturierten Löchern auf der Rückseite der gesamten Anordnung auf die Abstandsschicht aufgebracht. Der Krümmungsradius der Mikrolinsen 1' ist genau so eingestellt, dass sie auf die Detektorpixel 8 bzw. die diese abdeckenden Lochblenden 6' fokussieren.

Es wird somit ein Optowafer hergestellt, mit dem eine Mehrzahl von flachen Kameras realisierbar ist. Dabei ist eine Photostrukturierung der Abstandsschicht 5 für die Waferscale-Montage des hergestellten Optowafers mit einem Wafer, auf dem sich die Detektorpixel 8 befinden, vorteilhaft. Diese Strukturierung wird so vorgenommen, dass zwischen zwei benachbarten Anordnungen für die spätere flache Kamera eine Lücke hergestellt wird. Auf das Substrat 7 mit den Detektorpixeln 8 werden Bondingpads 12 aufgebracht, die zur späteren Kontaktierung der Detektorpixelmatrix benötigt sind. Der hergestellte Optowafer wird anschließend mit dem Wafer, auf dem sich die Detektorarrays befinden, z.B. durch Kleben und Aushärten verbunden, derart, dass die Lücke zwischen den Abstandsschichten 5 über den Bondingpads 12 liegen und ein Hohlraum von der Höhe der Abstandsschicht 5 gebildet wird. Anschließend werden die Kameras mittels einer Chipsäge vereinzelt. Durch den Hohlraum wird sichergestellt, dass mit einem Sägeblatt 13 zwar die Schichten 1-4 durchtrennt werden, aber nicht ungewollt die Schichten 6-8 beschädigt werden. Anschließend wird die Kamera mit mehreren nebeneinanderliegenden und unterschiedlich tiefen Schnitten entsprechend dem Sägeblatt 14 aus dem Waferverbund vereinzelt. So wird das Objektiv schmales ausgesägt als der Chip des Detektorarrays. Dadurch kann ein Kamerachip hergestellt werden, bei dem nach Vereinzelung der Detektorchip unter dem flachen Objektiv seitlich übersteht und damit die spätere Kontaktierbarkeit der Bondingpads 12 gewährleistet ist.

Im Folgenden werden die Parameter für dieses Beispiel entsprechend Figur 4 angegeben:

Dicken der verschiedenen Schichten bzw. Arrays [$\mu$m]: 1: 45; 2: 1,5; 3: 215; 4: 1,5; 5: 30; 6: 0,2;

Pitches (Mittenabstand bzw. Scheitelabstand) der verschiedenen Elemente in einem Array [$\mu$m]: 1: 107,2; 2: 107,2; 4: 106,15; 6: 106,0; 8: 106,0;

Durchmesser der Öffnungen der verschiedenen Elemente in einem Array [$\mu$m]: 1: 105; 2: 90; 4: 16; 6: 2;

Zahl der Elemente in einem Array: 84 x 64;

Krümmungsradius der Mikrolinsen 1': 103 $\mu$m;

Materialien: 1,5: UV-härtbares Photopolymer; 2,4: Black matrix polymer; 3: Glas; 7,8: CMOS Sensor

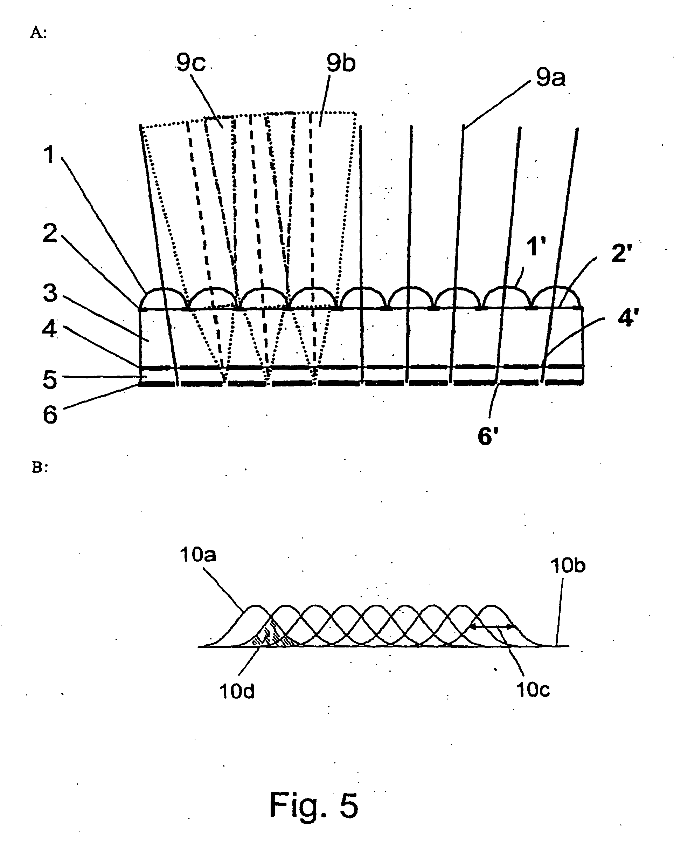

In Figur 5 ist ein Teil einer Kamera dargestellt, bei dem sich die Gesichtsfelder benachbarter optischer Kanäle teilweise überlappen, wobei eine solche Kamera für die höchstgenaue Positionsbestimmung von Punktquellen bzw. Positions- und Orientierungsbestimmung von Kanten dient. Ein solches bildgebendes System kann in Bereichen, in denen ein oder mehrere einfach strukturierten Objekte, wie solche Punktquellen und Kanten, mit einem kompakten abbildenden optischen System erfasst und die Winkelpositionen bzw. die lateralen Positionen bei bekanntem Objektabstand derselben innerhalb des Gesichtsfeldes mit hoher Genauigkeit und geringem Aufwand, d.h. geringer Datenmenge und kurzer Verarbeitungszeit bestimmt werden müssen, eingesetzt werden. Im industriellen Bereich ist eine Kantenpositionserkennung von großem Interesse, weiterhin sind Fahrstreifenmarkierungserkennung im Automobil oder Überwachungsaufgaben im Produktionsablauf denkbar.

Die überlappung der Gesichtsfelder entsprechend Figur 5 wird beispielsweise durch Einstellung des Zentrumsabstandes zwischen Linsenarray 1 und Lochblendenarray 6 bzw. Detektorarray oder durch die Vergrößerung der Lochblendendurchmesser erreicht, solange diese eine kleinere Flächenausdehnung aus die photosensitiven Detektorpixel 8 besitzen.

In Figur 5A ist mit 9a die Blickrichtung eines Kanals, d.h. die optische Achse, mit 9b das Gesichtsfeld des einzelnen optischen Kanals und mit 9c der Überlappungsbereich benachbarter Gesichtsfelder bezeichnet.

In Figur 5B ist die Winkelempfindlichkeit über den Winkel im Gesichtsfeld der ultra-flachen Kamera entsprechend Figur 5A aufgetragen, wobei 10a die Winkelempfindlichkeitskurve eines Kanals, 10b die Winkelachse, 10c die effektive Breite des Gesichtsfeldes eines Kanals und 10d den Überlappungsbereich der Winkelempfindlichkeitstcurve bezeichnen. Die zuvor beschriebenen Maßnahmen zur Überlappung der Gesichtsfelder benachbarter optischer Kanäle sorgen dafür, dass die Blickwinkeldifferenz zwischen benachbarten optischen Kanälen kleiner wird als die halbe, effektive Breite des Gesichtsfeldes eines Kanals. Eine solche Überlappung ist notwendig, damit ein Objektpunkt gleichzeitig mit verschiedenen Kanälen gesehen wird und unterschiedlich starke Signale gemessen werden können.

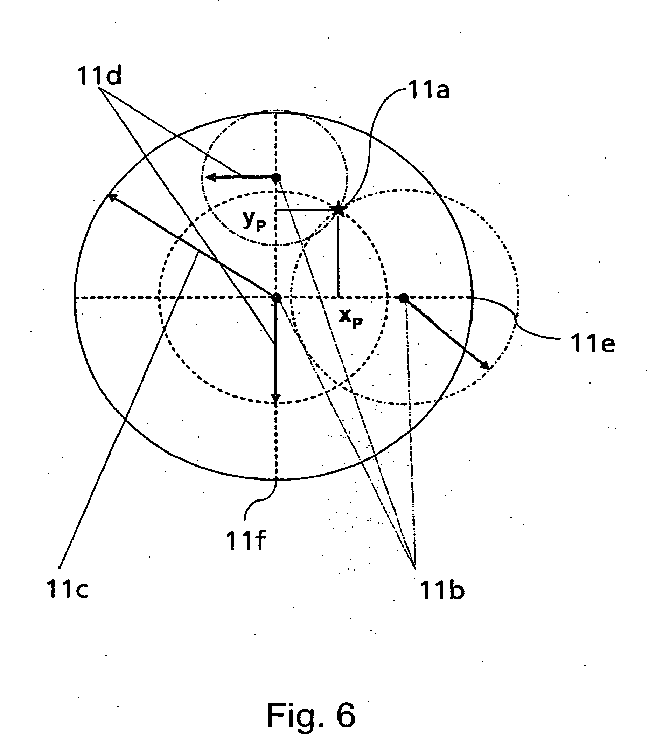

In Figur 6 ist die schematisierte Darstellung zur Bestimmung einer Winkelposition einer Punktquelle innerhalb des Gesichtsfeldes dreier optischer Kanäle mit überlappenden Gesichtsfeldern dargestellt. Dabei bezeichnet 11a die in die Bildebene projizierte Position der Punktquellen: 11b sind die Berührungspunkte der optischen Achsen der drei Kanäle mit der über die Brennweite projizierten Bildkoordinatenebene. 11e ist die Verbindungsachse von horizontalen benachbarten Kanälen (X-Achse) und 11f ist die Verbindungsachse von vertikalen benachbarten Kanälen (Y-Achse).

Mit dem Bezugszeichen 11d sind die Radien der projizierten Punktquellenposition innerhalb der Gesichtsfelder der einzelnen optischen Kanäle bezeichnet.

Bei der Bestimmung von Punktquellen oder punktförmigen Objekten ist zu beachten, dass die Verhältnisse der in den Lochblenden 6' benachbarter optischer Kanäle einer Kamera entsprechend Figur 5 gemessenen Intensitätswerte unabhängig von der absoluten Helligkeit des Objekts bzw. dem Emissionsvermögen der Lichtquelle sowie unabhängig von Schwankungen der absoluten Helligkeit bzw. des Emissionsvermögens ist, solange diese über die Integrationszeit des Detektors vernachlässigbar sind. Durch Auswertung eines Intensitätsverhältnisses können die Winkelposition der im gemeinsamen Gesichtsfeldbereich befindlichen Objekte bestimmt werden. Befindet sich ein solches Objekt im gemeinsamen Gesichtsfeld dreier optischer Kanäle entsprechend Figur 6 (mehrere optische Kanäle sind möglich), so wird je nach lateraler Entfernung der Punktquelle von der optischen Achse des jeweiligen Kanals eine spezifische Intensität in der zugehörigen. Lochblende 6' bzw. im nachfolgenden Detektorpixel 8 gemessen. Der formelmäßige Zusammenhang, welcher Anteil einer auf den optischen Kanal eingestrahlten Lichtmenge bei gegebenen Winkelabstand von der optischen Achse in die Bildebene übertragen wird, ist aus theoretischen Betrachtungen unter Benutzung der Winkelempfindlichkeit entsprechend 5B bekannt. Dieses Wissen wird benutzt, um aus den Verhältnissen der Intensitäten zweier benachbarter Lochblenden 6' die auf deren Verbindungsachsen über die Brennweite projizierte Koordinate $x_p$, $y_p$ der Punktquelle zu bestimmen. Nach der Berechnung der horizontalen und vertikalen Koordinaten $x_p$, $y_p$ der Punktquelle ist deren Winkelposition im Gesichtsfeld eines Bezugskanals und über die Zuordnung der Kanäle und ihrer Blickrichtung somit auch im Gesichtsfeld der gesamten ultra-flachen Kamera bekannt.

Das Berechnungsverfahren soll im folgenden Beispiel genauer erläutert werden.

Betrachtet man eine Achse der über die Brennweite projizierten Koordinaten im Gesichtsfeld des zentralen Kanals (Kennzeichnung 11e), in Figur 6, so wird die auf dieser Achse gemessene Position einer Punktquelle mit $x_p$ bezeichnet. Sie hängt mit der Winkelposition der Punktquelle im Gesichtsfeld des zentralen Kanals über die Beziehungen:

$$\left(\varphi_P = \arctan\left(\frac{r_P}{f}\right) \text{ und } r_P = \sqrt{x_P^2 + y_P^2}\right.$$

zusammen.

$\varphi_p$ beschreibt darin die Winkelposition der Punktquelle im Gesichtsfeld, $r_p$ die radiale Entfernung vom Berührungspunkt der optischen Achse mit der über die Brennweite projizierten Koordinatenebene sowie f die Brennweite des Objektivs. $y_p$ ist wie in Figur 6 vermerkt die Koordinate der Punktquelle auf der zweiten Koordinatenachse.

Aus theoretischen Grundlagen ist bekannt, dass sich die Intensitätsverteilung in der Bildebene jedes Kanals des Objektivs aus der mathematischen Faltung von der objektintensitätsverteilung mit der Winkelempfindlichkeitsfunktion (10a in Figur 5B) des entsprechenden Kanals ergibt. Für Objekte die mathematisch (näherungsweise) als Punktquellen bzw. Kanten beschrieben werden können, ist das Ergebnis der Faltung ein Zusammenhang, der sich aus der absoluten Helligkeit (bzw. dem absoluten Emissionsvermögen) der Quelle und dem Wert der Winkelempfindlichkeitsfunktion an der Position der Punktquelle ($x_p$, bzw. $r_p$ oder ($\varphi_p$), bzw. für Kanten zusätzlich aus einem Integralausdruck über die Winkelempfindlichkeitsfunktion an der Position der Kante, zusammensetzt. Durch den Überlapp der Gesichtsfelder benachbarter Kanäle werden in den jeweiligen Lochblenden 6 bzw. nachfolgenden Detektorpixeln 8 im Allgemeinen verschieden hohe Intensitäten gemäß dem beschriebenen Zusammenhang gemessen, wenn sich die Quelle im gemeinsamen Gesichtsfeldbereich der Kanäle befindet. Der Ausdruck, der durch das Verhältnis der in zwei benachbarten Kanälen gemessenen Intensitätswerte entsteht, ist unabhängig von der absoluten Helligkeit bzw. dem Emissionsvermögen der Quelle und kann nach der Koordinate der Punktquelle bzw. Kante in der projizierten Koordinatenebene ($x_p$) umgestellt werden.

Dieses Vorgehen wird für die zweite Koordinatenachse 11f in Figur 6 analog durchgeführt um $y_p$ zu erhalten und daraus die radiale Entfernung vom Berührungspunkt der optischen Achse mit der über die Brennweite projizierten Koordinatenebene ($r_p$) sowie die Winkelposition der Quelle im Gesichtsfeld des zentralen Kanals ($\varphi_p$) zu bestimmen.

Wenn das beschriebene Verfahren zur Kantenpositionsdetektion verwendet werden soll, muss zusätzlich die Orientierung der Kante zu der transversalen Hauptsymmetrieachsen der Kamera ermittelt werden. Dies wird in relativ einfacher Weise durch die Suche nach gleich großen Intensitäts- oder Kontrastwerten im Bild erreicht. Senkrecht zur auf diese Weise gefundenen Orientierung der Kanten werden dann nach dem oben beschriebenen Verfahren die Intensitätsverhältnisse verschiedener Detektorpixel ausgewertet, um die Kanten im Gesichtsfeld der Kamera mit hoher Genauigkeit zu ermitteln.

Das genannte Verfahren zur Positionsbestimmung kann in vereinfachter Form auch mit einer Kamera verwendet werden, die nur als eine Zeile ausgeführt ist. Es ist z.B. möglich, die Bewegung einer Kontrastkante im Gesichtsfeld dieser Zeile mit hoher Winkelauflösung zu erfassen.

**Patentansprüche**

1. Flache Kamera aus nebeneinander angeordneten optischen Kanälen mit jeweils zugeordneter Mikrolinse mit direkt darunter liegender Aperturblende und jeweils mindestens einem in der Bildebene liegenden Detektor, wobei die Detektoren (6', 8) derart angeordnet sind, dass die Richtungen der jeweils die verbindungslinien zwischen Linsenscheiteln und Zentrum der Detektoren bildenden optischen Achsen eine Funktion der Position des jeweiligen optischen Kanals darstellen,
**dadurch gekennzeichnet,**
**dass** zwischen den Mikrolinsen (1') mit direkt darunter liegender Aperturblende (2') und den in der Bildebene liegenden Detektoren (6', 8) mindestens eine als Schicht ausgebildete Blendenanordnung (4) zur Geisterbildunterdrückung und zwischen der Blendenanordnung (4) und den Detektoren (6', 8) eine aus einem Polymer gebildete und transparente Abstandsschicht (5) vorgesehen sind, wobei der Mittenabstand der Blenden (4') der Blendenanordnung (4) zwischen dem Scheitelabstand der Mikrolinsen (1') und dem Mittenabstand der Detektoren (6', 8) liegt, derart, dass je nach Position der Kanäle die Blenden (4') unterschiedlich versetzt zu den Mikrolinsen (1') und den Detektoren (6', 8) angeordnet sind und mit diesen jeweils auf einer Geraden liegen und wobei der Versatz der Blenden (4') der Blendenanordnung (4) in Bezug auf die Mikrolinsen (1') bzw, die Detektoren (6', 8) an den mit dem jeweiligen optischen Kanal abzubildenden Einfallswinkel angepasst ist.

2. Flache Kamera nach Anspruch 1, **dadurch gekennzeichnet, dass** die den jeweiligen Kanälen zugeordneten Detektoren (6', 8) zumindest teilweise derart angeordnet sind, dass sie in der Projektion der Mikrolinsen von jeweils benachbarten oder noch weiter weg liegenden Kanälen liegen.

3. Flache Kamera nach Anspruch 1 oder 2, **dadurch gekennzeichnet, dass** die Detektoren (5', 8) direkt als Detektorpixel (8) auf einem Substrat (7) oder als Detektorpixel mit vorgesetzter Lochblende (6') ausgebildet sind.

4. Flache Kamera nach einem der Ansprüche 1 bis 3,
**dadurch gekennzeichnet, dass** jeder optische Kanal mindestens ein bestimmtes Raumwinkelsegment als korrespondierenden Bildpunkt erfasst, derart, dass die Gesamtheit der übertragenen Bildpunkte auf der Detektoranordnung eine Rekonstruktion des Objektes erlaubt.

5. Flache Kamera nach einem der Ansprüche 1 bis 4,
**dadurch gekennzeichnet, dass** die einzelnen Mikrolinsen sich hinsichtlich ihrer Form, wie rund, elliptisch, sphärisch und dergleichen untereinander unterscheiden und/oder dass in die einzelnen Mikrolinsen Mikroprismen integriert sind.

6. Flache Kamera nach einem der Ansprüche 1 bis 5.
**dadurch gekennzeichnet, dass** zwischen den optischen Kanälen oder Gruppen von optischen Kanälen oder um die optischen Kanäle Lichtquellen angeordnet sind, wobei in der Bildebene der Mikrolinsen (1') mindestens ein Detektor (6', 8)
durch eine Lichtquelle ersetzt ist, die Licht von der Bildebene über die Mikrolinse (1') auf das zu beobachtende Objekt richtet, bündelt und/oder verteilt.

7. Flache Kamera nach einem der Ansprüche 1 bis 6, **dadurch gekennzeichnet, dass** sich die Gesichtsfelder benachbarter optischer Kanäle teilweise gegenseitig überlappen, wobei vorzugsweise die durch die optischen Achsen vorgegebene Blickwinkeldifferenz zwischen benachbarten optischen Kanälen kleiner ist als halbe Breite des Gesichtsfeldes eines Kanals.

8. Flache Kamera nach einem der Ansprüche 1 bis 7, **dadurch gekennzeichnet, dass** mehrere Blendenanordnungen (4) zur Geisterbildunterdrückung in unterschiedlichen Ebenen zwischen Mikrolinsen (1' und Detektoren (6', 8) angeordnet sind.

9. Flache Kamera nach Anspruch 8, **dadurch gekennzeichnet, dass** die Blendenanordnungen (4) unterschiedliche Mittenabstände aufweisen und/oder mit unterschiedlichen Abstandsschichten zueinander und zu den Detektoren oder den Mikrolinsen beabstandet sind.

10. Flache Kamera nach einem der Ansprüche 1 bis 9, **dadurch gekennzeichnet, dass** die optischen Kanäle und die Mikrolinsen (1') für eine Vergrößerung von etwa 1 ausgebildet sind, wobei der objektseitige Raumwinkel, der jedem Kanal als Bildpunkt zugeordnet ist, in seiner Größe so eingestellt ist, dass im Objektabstand des abbildenden Systems die diesem Raumwinkel entsprechende laterale Ausdehnung des Objekts gerade so groß wie der Abstand der Kanäle ist.

11. Flache Kamera nach einem der Ansprüche 1 bis 10, **dadurch gekennzeichnet, dass** auf einen transparenten Objektivkörper (3) vorderseitig das den Mikrolinsen (1') zugeordnete Aperturblendenarray (2) und rückseitig die Blendenanordnung (4) zur Geisterbildunterdrückung durch Beschichtung aufgebracht sind, auf das Aperturblendenarray (2) ein Mikrolinsenarray (1) und auf die Blendenanordnung (4) die transparente Abstandsschicht (5) angeordnet ist und unter der Abstandsschicht ein Substrat (7) mit einem Array aus Detektorpixeln (8) liegt, wobei ggf. ein Lochblendenarray (6) auf der Abstandsschicht (5) oder dem Substrat mit den Detektorpixeln aufgebracht ist.

12. Flache Kamera nach Anspruch 7.1, **dadurch gekennzeichnet, dass** der Objektivkörper (3) aus Glas, das Linsenarray und die Abstandsschicht aus einem strukturierbaren Polymer, das Aperturblendenarray (2) und die Blendenanordnung (4) zur Geisterbildunterdrückung aus einem absorbierenden Polymer oder Metall und das Lochblendenarray (6) aus einer Metall- oder Polymerschicht hergestellt ist.

13. Verfahren zur Herstellung mindestens einer flachen Kamera nach Anspruch 1 mit einem transparenten objektivkörper, auf dessen Vorderseite ein Aperturblendenarray (2) und Rückseite eine Blendenanordnung (4) zur Geisterbildunterdrückung aus dünnem absorbierenden Polymer oder einem Metall durch Beschichtung und Lithographie aufgebracht werden, dann vorderseitig ein Mikrolinsenarray (1) durch UV-Replikation und rückseitig eine Abstandsschicht (5), beide aus einem photostrukturierbaren Polymer, hergestellt werden und die Abstandsschicht gegebenenfalls nach Herstellung einer Anordnung aus Lochblenden (6') mit einem mit einem Detektorpixelarray versehenen Substrat verbunden wird, wobei die Detektoren bzw. die Detektoren mit Lochblende gegenüber dem Durchmesser der Mikrolinse um ein Vielfaches kleiner sind.

14. Verfahren nach Anspruch 13, **dadurch gekennzeichnet, dass** zur Bildung eines optowafers auf einen durchgehenden Objektivkörper mehrere Aperturblendenarrays und Blendenanordnungen, mehrere Mikrolinsenarrays und mehrere mit Abstand zueinander angeordnete Abstandsschichten aufgebracht werden, die mit einem Detektorwafer mit einer Mehrzahl von Detektorpixelarrays und zwischen dem Detektorpixelarrays auf dem Wafer aufgebrachten Bondingpads derart verbunden werden, dass die freibleibenden Räume zwischen den Abstandschichten über den Bondingpads liegen und dass die so verbundenen Opto- und Detektorwafer durch mehrere nebeneinanderliegende und unterschiedlich tiefe Schnitte mit einer Säge so vereinzelt werden, dass Kamerachips hergestellt werden, bei denen die Bondingpads auf den Detektorchips seitlich über die übrige Anordnung herausragen.

15. Verwendung einer flachen Kamera nach einem Ansprüche 7 bis 12 mit einer Auswerteeinrichtung zur Positionsbestimmung von punktförmigen Objekten unter Heranziehung der Verhältnisse der von den Detektoren erfassten Intensitäten benachbarter optischer Kanäle oder mit einer Auswerteeinrichtung zur Orientierungs- und Positionsbestimmung von Kanten durch Auswertung der von den Detektoren erfassten Intensitätswerte oder Kontrastwerte und unter Heranziehung der Verhältnisse der Intensität benachbarter optischer Kanäle.

**Claims**

1. A flat camera of optical channels arranged next to one another, in each case with an assigned microlens with an aperture lying directly below and in each case at least one detector lying in the image plane, wherein the detectors (6', 8) are arranged in a manner such that the directions of the respective optical axes forming in each case the connection lines between the lens apexes and the centre of the detectors, represent a function of the position of the respective optical channel,
**characterised in that**
at least one aperture diaphragm arrangement (4) for ghost image suppression being arranged as a layer is provided between the microlenses (1') with aperture (2') lying directly below, and the detectors (6', 8) lying in the image plane, and between the aperture diaphragm arrangement (4) and the detectors (6, 8') a transparent distance layer (5) made of a polymer is provided, wherein the centre-to-centre distance of the aperture diaphragms (4') lies between the apex distance of the microlenses (1') and the centre-to-centre distance of the detectors (6', 8), in a manner such that depending on the position of the channels, the aperture diaphragms (4') are arranged differently offset to the microlenses (1') and the detectors (6', 8), and in each case lie on a straight line with these and wherein the offset of the aperture diaphragms (4') of the aperture diaphragm arrangement (4), with respect to the microlenses (1') or the detectors (6', 8), is adapted to the incidence angles to be imaged with the respective optical channel.

**2.** A flat camera according to claim 1, **characterised in that** the detectors (6,' 8') assigned to the respective channels are at least partly arranged in a manner, such that they lie in the projection of the microlenses of in each case adjacent channels or ones lying even further away.

**3.** A flat camera according to claim 1 or 2, **characterised in that** the detectors (6', 8) are designed directly as detector pixels (8) on a substrate (7), or as detector pixels with a hole diaphragm (6') set in front.

**4.** A flat camera according to one of the claims 1 to 3, **characterised in that** each optical channel detects at least one certain solid angle segment as a corresponding image point, in a manner such that the entirety of the transmitted image points on the detector arrangement permits a reconstruction of the object.

**5.** A flat camera according to one of the claims 1 to 4, **characterised in that** the individual microlenses have different shapes such as round, elliptical, aspheric and likewise and/or that microprisms are integrated into the individual microlenses.

**6.** A flat camera according to one of the claims 1 to 5, **characterised in that** light sources are arranged between the optical channels or groups of optical channels, or around the optical channels, wherein in the image plane of the microlenses (1'), at least one detector (6', 8) is replaced by a light source which directs, bundles and/or distributes the light from the image plane via the microlens (1'), onto the object to be observed.

**7.** A flat camera according to one of the claims 1 to 6, **characterised in that** the visual fields of adjacent optical channels partly mutually overlap, wherein preferably the viewing angle difference between adjacent optical channels which is set by the optical axes, is smaller than half the width of the visual field of a channel.

**8.** A flat camera according to one of the claims 1 to 7, **characterised in that** several aperture diaphragm arrangements (4) for ghost image suppression are arranged in different planes between microlenses (1') and detectors (6', 8).

**9.** A flat camera according to claim 8, **characterised in that** the aperture diaphragm arrangements (4) have different centre-to-centre distances to one another, and/or with different distance layers, are distanced to one another, and to the detectors or microlenses.

**10.** A flat camera according to one of the claims 1 to 9, **characterised in that** the optical channels and the microlenses (1') are designed for an enlargement of about 1, wherein the object-side solid angle which is assigned to each channel as an image point, is set with regard to its size such that in the object distance of the imaging system, the lateral extension of the object which corresponds to this solid angle is just as large as the distance of the channels.

**11.** A flat camera according to one of the claims 1 to 10, **characterised in that** an aperture diaphragm array (2) assigned to the microlenses (1') and the aperture diaphragm arrangement (4) for ghost image suppression, by way of coating, are deposited onto a transparent objective body (3) on the front side and the rear side, a microlens array (1) is arranged on the aperture diaphragm array (2), and a transparent distance layer (5) on the aperture diaphragm arrangement (4), and a substrate (7) with an array of detector pixels (8) lies below the distance layer, wherein, as the case may be, a hole diaphragm array (6) is deposited on the distance layer (5) or the substrate with the detector pixels.

**12.** A flat camera according to claim 11, **characterised in that** the objective body (3) consists of glass, the lens array and the distance layer of a structured polymer, the aperture diaphragm array (2) and the aperture diaphragm arrangement (4) for ghost image suppression of an absorbing polymer or metal, and the hole diaphragm array (6) of metal layer or polymer layer.

**13.** A method for manufacturing at least one flat camera according to claim 1 with a transparent objective body, on whose front side an aperture diaphragm array (2) and on whose rear side an aperture diaphragm arrangement (4) for ghost image suppression of thin absorbing polymer or a metal is deposited by way of coating and lithography, then a microlens array (1) is manufactured on the front side by way of UV-replication, and a distance layer on a rear side, both of a photo-structurisable polymer, and, as the case may be, the distance layer is connected to the substrate provided with a detector pixel array after manufacturing an array of hole diaphragms (6'), wherein the detectors or the detectors with hole diaphragms, respectively, are much smaller than the diameter of the microlenses.

**14.** A method according to claim 13, **characterised in that** for forming an optowafer, several aperture diaphragm arrays and aperture diaphragm arrangements, several microlens arrays and several distance layers arranged at a distance to one another, are deposited onto a continuous objective body, and are connected to a detector wafer with a plurality of detector pixel arrays and bonding pads deposited between the detector pixel arrays on the wafer, in a manner such that the spaces remaining free between the distance layers lie above the bonding pads, and that the optowafers and detector wafers connected in such a manner are singularised with a saw by several differently deep cuts lying next to one another such that camera chips are manufactured, with which the bonding pads on the detector chips laterally project beyond the remaining arrangement.

15. The use of a flat camera according to one of the claims 7 to 12, with an evaluation device for the position evaluation of point-like objects whilst utilising the relations of the intensities of adjacent optical channels, which are detected by the detectors or with an evaluation device for the orientation evaluation and position evaluation of edges by way of evaluating intensity values or contrast values, detected by the detectors, and using the relations of the intensities of adjacent optical channels.

**Revendications**

1. Caméra plate constituée de canaux optiques disposés l'un à côté de l'autre et assortis respectivement d'une microlentille avec un diaphragme d'ouverture positionné directement en-dessous et respectivement d'au moins un détecteur situé dans le plan image, dans laquelle les détecteurs (6', 8) sont disposés de sorte que les directions des axes optiques formant les lignes de connexion entre les sommets des surfaces des lentilles et le centre des détecteurs représentent une fonction de la position du canal optique respectif, **caractérisée en ce qu'**entre les microlentilles (1') avec un diaphragme d'ouverture (2') positionné directement en-dessous et les détecteurs (6', 8) positionnés dans le plan image, au moins un dispositif de diaphragmes (4) se présentant sous forme de couche est prévu pour la suppression d'image fantôme et **en ce qu'**entre le dispositif de diaphragmes (4) et les détecteurs (6', 8), une couche d'espacement transparente formée d'un polymère est prévue, où la distance de centre à centre des diaphragmes (4') du dispositif de diaphragmes (4) se situe entre la distance des sommets des surfaces des microlentilles (1') et la distance de centre à centre des détecteurs (6', 8), de sorte qu'en fonction de la position des canaux, les diaphragmes (4') soient différemment décalés par rapport aux microlentilles (1') et aux détecteurs (6', 8) et disposés respectivement avec eux sur une ligne droite, et où le décalage des diaphragmes (4') du dispositif de diaphragmes (4) par rapport aux microlentilles (1') ou aux détecteurs (6', 8) est adapté à l'angle d'incidence à reproduire avec le canal optique respectif.

2. Caméra plate selon la revendication 1, **caractérisée en ce que** les détecteurs (6', 8) affectés aux canaux respectifs sont disposés au moins en partie de sorte qu'ils se trouvent dans la projection des microlentilles de canaux respectivement adjacents ou plus distancés encore.

3. Caméra plate selon la revendication 1 ou 2, **caractérisée en ce que** les détecteurs (6', 8) se présentent directement sous la forme de pixels détecteurs (8) sur un substrat (7) ou sous la forme de pixels détecteurs avec un diaphragme à trou disposé en amont (6').

4. Caméra plate selon l'une quelconque des revendications 1 à 3, **caractérisée en ce que** chaque canal optique capte au moins un segment d'angle solide déterminé comme point d'image correspondant de sorte que la totalité des points d'image transmis sur le dispositif de détecteurs permet de reconstruire l'objet.

5. Caméra plate selon l'une quelconque des revendications 1 à 4, **caractérisée en ce que** les microlentilles individuelles se différencient entre elles par leur forme, pouvant être ronde, elliptique, asphérique et similaire et/ou **en ce que** des microprismes sont intégrés aux microlentilles individuelles.

6. Caméra plate selon l'une quelconque des revendications 1 à 5, **caractérisée en ce que** des sources de lumière sont disposées entre les canaux optiques ou des groupes de canaux optiques ou autour des canaux optiques, dans laquelle au moins un détecteur (6', 8) est remplacé, dans le plan image des microlentilles (1'), par une source de lumière, qui, via la microlentille (1'), oriente, concentre et/ou diffuse de la lumière du plan image vers l'objet à observer.

7. Caméra plate selon l'une quelconque des revendications 1 à 6, **caractérisée en ce que** les champs optiques de canaux optiques voisins se chevauchent, en partie, mutuellement, dans laquelle, de préférence, la différence d'angle de visée entre des canaux optiques voisins, prédéfinie par les axes optiques, est plus petite que la demi-largeur du champ optique d'un canal.

8. Caméra plate selon l'une quelconque des revendications 1 à 7, **caractérisée en ce que** plusieurs dispositifs de diaphragmes (4) pour la suppression d'image fantôme sont disposés, dans différents plans, entre les microlentilles (1') et les détecteurs (6', 8).

9. Caméra plate selon la revendication 8, **caractérisée en ce que** les dispositifs de diaphragmes (4) présentent de différentes distances de centre à centre et/ou sont espacés entre eux et par rapport aux détecteurs ou aux microlentilles par différentes couches d'espacement

10. Caméra plate selon l'une quelconque des revendications 1 à 9, **caractérisée en ce que** les canaux optiques et les microlentilles (1') sont constitués pour un grossissement d'environ 1, dans laquelle l'angle solide côté objet, qui est attribué à chaque canal comme point d'image, est réglé au niveau de sa grandeur de sorte qu'à la distance de l'objet du système de reproduction, l'extension latérale de l'objet correspondant à cet angle solide est tout juste aussi grande que l'espacement des canaux.

11. Caméra plate selon l'une quelconque des revendications 1 à 10, **caractérisée en ce que** l'on applique sur la face avant d'un corps d'objectif transparent, par procédé de revêtement, le réseau de diaphragmes d'ouverture affecté aux microlentilles (1') et, sur sa face arrière, le dispositif de diaphragmes (4) pour la suppression d'image fantôme, **en ce qu'**un réseau de microlentilles (1) est disposé sur le réseau de diaphragmes d'ouverture (2) et la couche d'espacement transparente (5) sur le dispositif de diaphragmes et **en ce qu'**un substrat (7) avec un réseau de pixels détecteurs (8) est placé en-dessous de la couche d'espacement, dans laquelle, le cas échéant, un réseau de diaphragmes à trou (6) est appliqué sur la couche d'espacement (5) ou sur le substrat avec les pixels détecteurs.

12. Caméra plate selon la revendication 11, **caractérisée en ce que** le corps d'objectif (3) est fabriqué à partir de verre, le réseau de lentilles et la couche d'espacement à partir d'un polymère structurable, le réseau de diaphragmes d'ouverture (2) et le dispositif de diaphragmes (4) pour la suppression d'image fantôme à partir d'un polymère absorbant ou de métal et le réseau de diaphragmes à trou (6) à partir d'une couche de polymère ou de métal.

13. Procédé de fabrication d'au moins une caméra plate selon la revendication 1, comprenant un corps d'objectif transparent (2), sur lequel sont appliqués, par procédé de revêtement et de lithographie, un réseau de diaphragmes d'ouverture (2), en face avant, et un dispositif de diaphragmes (4) pour la suppression d'image fantôme, en face arrière, constitués de polymère mince et absorbant ou d'un métal, où l'on fabrique ensuite, par réplication UV, un réseau de microlentilles (1) en face avant et une couche d'espacement (5) en face arrière, tous deux constitués d'un polymère photo-structurable et que l'on relie la couche d'espacement, le cas échéant après la fabrication d'un dispositif de diaphragmes à trou (6'), à un substrat pourvu d'un réseau de pixels détecteurs, dans lequel la taille des détecteurs ou des détecteurs pourvus de diaphragmes à trou est de multiples fois inférieure au diamètre des microlentilles.

14. Procédé selon la revendication 13, **caractérisé en ce que**, pour former un wafer optique, l'on applique, sur un corps d'objectif continu plusieurs réseaux de diaphragmes d'ouverture et dispositifs de diaphragmes, plusieurs réseaux de microlentilles et plusieurs couches d'espacement disposées à distance l'une de l'autre, qui sont reliés à un wafer détecteur ayant une pluralité de réseaux de pixels détecteurs et à des plots de connexion, appliqués entre les réseaux de pixels détecteurs sur le wafer, de sorte que les espaces restant libres entre les couches d'espacement se situent au-dessus des plots de connexion et que les wafers optiques et détecteurs ainsi reliés sont individualisés par plusieurs coupes de scie effectuées côte à côte par différentes profondeurs, de façon à fabriquer des puces de caméra, les plots de connexion sur les puces détectrices dépassant latéralement du dispositif restant.

15. Utilisation d'une caméra plate selon les revendications 7 à 12, comprenant un dispositif d'exploitation pour déterminer la position d'objets en forme de points en tenant compte des rapports des intensités des canaux optiques adjacents captées par les détecteurs ou comprenant un dispositif d'exploitation pour déterminer l'orientation et la position d'arêtes en exploitant des valeurs d'intensité ou des valeurs de contraste captées par les détecteurs et en tenant compte des rapports de l'intensité de canaux optiques adjacents.

1

2

3

4

5

6

7

8

2'

1'

4'

6'

Fig. 1

Fig. 2

Fig. 4

Fig. 3

A:

9c    9b    9a

1
2
3    1'    2'
4    4'
5
6    6'

B:

10a    10b

10d    10c

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2005069607 A1
- WO 2005069607 A
- JP 2001237404 A